**Europäisches Patentamt**

**European Patent Office**

**Office européen des brevets**

(19)

(11) Veröffentlichungsnummer: **0 101 010**

**A1**

(12) # EUROPÄISCHE PATENTANMELDUNG

(21) Anmeldenummer: **83107644.3**

(22) Anmeldetag: **03.08.83**

(51) Int. Cl.³: **G 03 F 7/26**
**G 03 F 7/08**

(30) Priorität: **13.08.82 DE 3230171**

(43) Veröffentlichungstag der Anmeldung:
**22.02.84 Patentblatt 84/8**

(84) Benannte Vertragsstaaten:
**IT**

(71) Anmelder: **HOECHST AKTIENGESELLSCHAFT**
**Postfach 80 03 20**
**D-6230 Frankfurt am Main 80(DE)**

(72) Erfinder: **Simon, Ulrich, Dr. Dipl.-Chem.**
**Fontanestrasse 41**
**D-6500 Mainz-Lerchenberg(DE)**

(72) Erfinder: **Beutel, Rainer**
**Wiesenhain 8**
**D-6200 Wiesbaden-Breckenheim(DE)**

(54) **Wässrig-alkalische Lösing und Verfahren zum Entwickeln von positiv-arbeitenden Schichten.**

(57) Die wäßrig-alkalische Entwicklerlösung für strahlungs-empfindliche, positiv-arbeitende Reproductionsschichten enthält Silikat und eine quaternäre Ammoniumbase wie Tetraalkyl-ammoniumhydroxid; sie kann auch noch ein Salz einer organischen, gegebenenfalls substituierten, aromatischen Monocarbonsäure, wie ein Benzoat, enthalten. Diese Lösung wird insbesondere zur Entwicklung von Reproduktionsschichten eingesetzt, die ein o-Naphthochinondiazid als strahlungsempfindliche Verbindung und ein alkalilösliches Harz enthalten, und die sich auf einem Trägermaterial auf der Basis von Aluminium befinden, das mindestens eine anodisch erzeugte Aluminiumoxidschicht aufweist.

EP 0 101 010 A1

0101010

HOECHST AKTIENGESELLSCHAFT
KALLE Niederlassung der Hoechst AG

Hoe 82/K 043          - 1 -          2. August 1983
WLK-Dr.I.-wf

Wäßrig-alkalische Lösung und Verfahren zum Entwickeln von positiv-arbeitenden Reproduktionsschichten

Die Erfindung betrifft eine wäßrig-alkalische Entwicklerlösung für strahlungsempfindliche, positiv-arbeitende Reproduktionsschichten auf der Basis von Silikaten und mindestens einer weiteren Komponente und ein Verfahren zum Entwickeln der genannten Schichten.

Strahlungs(licht)empfindliche Reproduktionsschichten werden beispielsweise bei der Herstellung von Offsetdruckformen oder von Photoresists (beides im weiteren Kopiermaterialien genannt) verwendet, d. h. sie werden im allgemeinen vom Verbraucher oder vom industriellen Hersteller auf einen Schichtträger aufgebracht. Als Schichtträger in diesen Kopiermaterialien werden Metalle wie Zink, Magnesium, Chrom, Kupfer, Messing, Stahl, Silicium, Aluminium oder Kombinationen dieser Metalle, Kunststoffolien, Papier oder ähnliche Materialien eingesetzt. Diese Schichtträger können ohne eine modifizierende Vorbehandlung, bevorzugt aber nach Durchführung einer Oberflächenmodifizierung wie·einer mechanischen, chemischen und/oder elektrochemischen Aufrauhung, einer Oxidation und/oder einer Behandlung mit Hydrophilierungsmitteln (z. B. bei Trägern für Offsetdruckplatten), mit der strahlungsempfindlichen Reproduktionsschicht beschichtet werden. Die üblichen Reproduktionsschichten enthalten neben mindestens einer strahlungsempfindlichen Verbindung meist noch ein organisches Bindemittel (Harze o. ä.) und gege-

HOECHST   AKTIENGESELLSCHAFT
KALLE   Niederlassung der Hoechst AG

- 2 -

benenfalls auch noch Weichmacher, Pigmente, Farbstoffe, Netzmittel, Sensibilisatoren, Haftvermittler, Indikatoren und andere übliche Hilfsmittel. Die Reproduktionsschichten werden nach ihrer Belichtung entwickelt, um aus ihnen ein Bild zu erzeugen, beispielsweise wird so eine Druckform oder ein Photoresist erhalten.

Ein Entwickler für positiv-arbeitende Reproduktionsschichten muß die von elektromagnetischer Strahlung getroffenen Schichtteile (die späteren Nichtbildstellen) aus der belichteten Schicht herauslösen können, ohne dabei die von der Strahlung nicht getroffenen Teile (die späteren Bildstellen) der Schicht wesentlich zu beeinflussen. In der beispielhaft zu nennenden DE-PS 12 00 133 (= US-PS 3 110 596) werden als geeignete Entwickler beispielsweise aufgeführt: alkalisch-wäßrige Lösungen von Phosphaten, Silikaten, Fluorosilikaten, Stannaten, Fluoroboraten oder Fluorotitanaten, die gegebenenfalls auch noch wasserlösliche Hydrokolloide oder organische Lösemittel enthalten können.

Um diese wäßrig-alkalischen Entwicklerlösungen zu verbessern, wurden im Stand der Technik auch bereits verschiedenste Alternativen oder Modifizierungen beschrieben:

In der DE-OS 28 34 958 (= ZA-PS 79/4131) wird ein Verfahren zum Entwickeln von positiv-arbeitenden lichtempfindlichen Schichten auf der Basis von o-Naphthochinondiaziden und alkalilöslichen Harzen beschrieben, bei dem die belichteten Schichtbereiche mit einer wäßrig-alkalischen

HOECHST AKTIENGESELLSCHAFT
KALLE Niederlassung der Hoechst AG

- 3 -

Entwicklerlösung ausgewaschen werden, die a) eine alkalisch reagierende Verbindung wie Wasserglas, Na-metasilikat, $Na_3PO_4$, $K_3PO_4$, $Na_2HPO_4$, $K_2HPO_4$, NaOH, KOH, Diethylamin, Ethanolamin oder Trietholamin, und b) ein Salz,
Oxid oder Hydroxid eines Elements der II. oder III. Hauptgruppe oder der III. Nebengruppe des Periodensystems der
Elemente wie des Calciums, Strontiums oder Bariums enthält.

Aus der GB-PS 1 591 988 ist ein Entwicklungsverfahren für
positiv-arbeitende lichtempfindliche Schichten auf der Basis von o-Naphthochinondiazidestern und alkalilöslichen
Harzen bekannt, bei dem der Entwickler a) 75 bis 99,5
Vol.-% einer wäßrig-alkalischen Lösung wie einer wäßrig-
alkalischen Na-metasilikat- oder $Na_3PO_4$-Lösung und b)
0,5 bis 25 Vol.-% eines organischen Lösemittels wie Alkanole oder Alkandiole (oder deren Monoether) enthält.
Als weitere Komponenten werden auch NaOH, Na-benzoat,
Dimethylformamid, Polyethylenglykol, $Na_2HPO_4$ und Tetranatriumethylendiamintetraacetat genannt.

M. J. Grieco et al. in IBM-Technical Disclosure Bulletin,
Vol. 13, Nr. 7, 12/1970, S. 2009, nennen wäßrig- oder alkoholisch-alkalische Lösungen (ohne Gehalt an $Na^+$-Ionen)
mit einem pH-Wert im Bereich von 9 bis 13 und einem Gehalt von 5 bis 25 % an Tetramethyl-ammoniumhydroxid als
geeignet zur Entwicklung von positiv-arbeitenden Photoresists.

Bei der Herstellung von Halbleiterschichten nach der

HOECHST AKTIENGESELLSCHAFT
KALLE Niederlassung der Hoechst AG

– 4 –

JP-OS 158 280/75 (veröffentlicht am 22. Dezember 1975) werden positiv-arbeitende Photoresists auf der Basis von o-Naphthochinondiaziden und Novolakharzen mit einer wäßrigen, 1 bis 4 Gew.-% an Tetramethyl-ammoniumhydroxid enthaltenden Lösung entwickelt.

In der JP-AS 4423/78 (bekanntgemacht am 17. Februar 1978) werden wäßrige oder alkoholische Lösungen von Tetraalkylammoniumhydroxid (Alkyl von $C_1$ bis $C_7$) als geeignet zur Entwicklung von positiv-arbeitenden Photoresists auf der Basis von o-Naphthochinondiaziden und Novolakharzen beschrieben. Auch Tetrahydroxyethyl-ammoniumhydroxid wird als Entwicklerkomponente genannt, aber als weniger geeignet bezeichnet.

Aus der DE-OS 23 12 499 (= GB-PS 1 367 830) sind positiv-arbeitende Photoresists auf der Basis von Diazochinon-Siloxanen und alkalilöslichen Bindemitteln bekannt, die mit einer wäßrigen Lösung entwickelt werden, die 1,7 Gew.-% Tetramethyl-ammoniumhydroxid und ein anionisches Tensid enthalten.

Der Entwickler für positiv-arbeitende, Chinondiazide enthaltende lichtempfindliche Schichten auf den Gebieten Photoresists und Druckplatten gemäß der US-PS 4 141 733 enthält in wäßriger Lösung 1 bis 30 Gew.-% Methyl-trihydroxyethyl-ammoniumhydroxid. In Vergleichsbeispielen werden auch Tetramethyl-, Tetraethyl-, Benzyl-methyldihydroxyethyl- und Benzyl-hydroxyethyl-dimethyl-ammoniumhydroxid eingesetzt. Quaternäre Ammoniumhydroxide, die mindestens eine Hydroxyalkylgruppe tragen, können nach der EP-OS 0 023 758 (= US-PS 4 294 911) in Entwicklern durch Zugabe von Sulfiten, Hydrosulfiten oder Pyrosulfiten (Disulfite, Metasulfite) stabilisiert werden.

Die bekannten Entwickler weisen jedoch noch einige Nachteile auf, beispielsweise greifen sie oftmals die Aluminiumoxidschicht der Trägermaterialien von Druckplatten an, oder sie bewirken eine zu flache Gradation (zu wenig steile Gradation) in den Bildstellen.

Aufgabe der vorliegenden Erfindung ist es deshalb, einen Entwickler für positiv-arbeitende, strahlungsempfindliche Reproduktionsschichten vorzuschlagen, aus dessen Anwendung eine Druckform ohne nennenswerten Angriff am Trägermaterial dieser Schichten resultiert, die in den Bildstellen eine relativ steile Gradation bei gutem Auflösevermögen zeigt.

Die Erfindung geht aus von der bekannten wäßrig-alkalischen Entwicklerlösung für strahlungsempfindliche, positiv-arbeitende Reproduktionsschichten auf der Basis von Silikaten und mindestens einer weiteren Komponente. Die erfindungsgemäße Entwicklerlösung ist dann dadurch gekennzeichnet, daß sie eine quaternäre Ammoniumbase enthält. Unter den Begriff "quaternäre Ammoniumbase" sollen nicht nur bereits außerhalb der wäßrig-alkalischen Entwicklerlösung als Basen vorliegende Verbindungen fallen, sondern auch solche - wie beispielsweise quaternäre Ammoniumsalze, die in der Entwicklerlösung dissoziieren -,

HOECHST AKTIENGESELLSCHAFT
KALLE Niederlassung der Hoechst AG

- 5A -

die quaternäre Ammoniumionen liefern, die in der wäßrig-alkalischen Lösung im Ionengleichgewicht vorliegen. Die quaternäre Ammoniumbase ist insbesondere ein Tetraalkyl-ammoniumhydroxid, dessen Alkylsubstituenten gleich oder verschieden sind und ein bis 6 C-Atome enthalten. Dazu zählen beispielsweise:

Tetramethyl-ammoniumhydroxid        (TMAH)
Tetraethyl-ammoniumhydroxid         (TEAH)
Tetrapropyl-ammoniumhydroxid        (TPAH)
Tetrabutyl-ammoniumhydroxid         (TBAH)
Tributyl-methyl-ammoniumhydroxid (TBMAH)

Die wäßrig-alkalische Entwicklerlösung enthält neben dem Lösemittel Wasser in der Hauptsache ein Silikat, insbesondere ein Alkalisilikat wie Natriummetasilikat, bevorzugt in einer Menge von 5 bis 15 Gew.-%, insbesondere von 6 bis 13 Gew.-%. Bei relativ niedrigen Silikatkonzentrationen kann es - abhängig von der in der Lösung vorhandenen Menge der übrigen Komponenten - nach der Entwicklung zum Auftreten von "Ton" kommen. Dieser Effekt kann jedoch durch Abänderung der Konzentration oder Art der anderen Komponenten verhindert werden.

Die quaternäre Ammoniumbase ist in dieser wäßrig-alkalischen Entwicklerlösung zweckmäßig in einem Anteil von 0,001 bis 1,0 Gew.-%, insbesondere von 0,002 bis 0,1 Gew.-%, vorhanden. Bevorzugte Entwicklerlösungen enthalten zusätzlich noch ein Salz einer organischen, gegebenenfalls substituierten aromatischen Monocarbonsäure, insbesondere ein Alkalisalz von gegebenenfalls substituierter Benzoesäure wie Natriumbenzoat oder -salicylat, in einer Menge von 0,01 bis 10,0 Gew.-%, insbesondere von 0,1 bis 5,0 Gew.-%. Neben den bereits genannten Komponenten kann die erfindungsgemäße Entwicklerlösung gegebenenfalls auch noch übliche Zusätze wie ionogene oder nichtionogene Tenside, Antischaummittel, die Visko-

HOECHST AKTIENGESELLSCHAFT
KALLE Niederlassung der Hoechst AG

- 7 -

sität beeinflussende Mittel, Konservierungsmittel, Komplexbildner oder - maximal bis zu 5 Gew.-% - mit Wasser mischbare organische Lösemittel enthalten.

Eine weitere Lösung der gestellten Aufgabe ist auch ein Verfahren zum Entwickeln von belichteten, strahlungsempfindlichen, positiv-arbeitenden Reproduktionsschichten auf einem Trägermaterial auf der Basis von Aluminium, bei dem die belichteten Schichtbereiche mit der erfindungsgemäßen Entwicklerlösung ausgewaschen werden.

Die zu entwickelnde Reproduktionsschicht liegt insbesondere als Teil (strahlungsempfindliche Schicht) einer Offsetdruckplatte oder als auf ein Trägermaterial aufgebrachter Resist (Photoresistschicht) vor. Als Trägermaterial kommt bevorzugt Aluminium oder eine seiner Legierungen in Betracht. Die Träger können ohne eine spezielle modifizierende Vorbehandlung mit einer geeigneten Reproduktionsschicht versehen werden, bevorzugt wird diese Beschichtung jedoch erst nach einer Oberflächenmodifizierung wie einer mechanischen, chemischen und/oder elektrochemischen Aufrauhung, einer Oxidation und/oder einer Behandlung mit Hydrophilierungsmitteln (insbesondere bei Trägern für Offsetdruckplatten) durchgeführt.

Die in der Praxis sehr häufig anzutreffenden Aluminiumträgermaterialien für Druckplatten mit einem Gehalt von mehr als 98,5 Gew.-% Al und Anteilen an Si, Fe, Ti, Cu und Zn werden im allgemeinen vor Aufbringen der strah-

0101010

lungsempfindlichen Schicht noch mechanisch (z. B. durch
Bürsten und/oder mit Schleifmittel-Behandlungen), chemisch (z. B. durch Ätzmittel) oder elektrochemisch (z.
B. durch Wechselstrombehandlung in wäßrigen HCl- oder
$HNO_3$-Lösungen) aufgerauht. Die mittlere Rauhtiefe $R_z$
der aufgerauhten Oberfläche liegt dabei im Bereich von
etwa 1 bis 15 µm. Die Rauhtiefe wird nach DIN 4768 in
der Fassung vom Oktober 1970 ermittelt, die Rauhtiefe
$R_z$ ist dann das arithmetische Mittel aus den Einzelrauhtiefen fünf aneinandergrenzender Einzelmeßstrecken.

Nach dem bevorzugt angewendeten elektrochemischen Aufrauhverfahren schließt sich dann in einer weiteren, gegebenenfalls anzuwendenden Verfahrensstufe eine anodische
Oxidation des Aluminiums an, um beispielsweise die Abriebs-
und Haftungseigenschaften der Oberfläche des Trägermaterials zu verbessern. Zur anodischen Oxidation können
die üblichen Elektrolyte wie $H_2SO_4$, $H_3PO_4$, $H_2C_2O_4$, Amidosulfonsäure, Sulfobernsteinsäure, Sulfosalicylsäure oder
deren Mischungen eingesetzt werden. Es wird beispielsweise auf folgende Standardmethoden für den Einsatz von
$H_2SO_4$ enthaltenden wäßrigen Elektrolyten für die anodische Oxidation von Aluminium hingewiesen (s. dazu z. B.
M. Schenk, Werkstoff Aluminium und seine anodische
Oxydation, Francke Verlag - Bern, 1948, Seite 760; Praktische Galvanotechnik, Eugen G. Leuze Verlag - Saulgau,
1970, Seiten 395 ff und Seiten 518/519; W. Hübner und
C. T. Speiser, Die Praxis der anodischen Oxidation des
Aluminiums, Aluminium Verlag - Düsseldorf, 1977, 3. Auflage, Seiten 137 ff):

HOECHST AKTIENGESELLSCHAFT
KALLE Niederlassung der Hoechst AG

- 9 -

- Das Gleichstrom-Schwefelsäure-Verfahren, bei dem in einem wäßrigen Elektrolyten aus üblicherweise ca. 230 g $H_2SO_4$ pro 1 l Lösung bei 10° bis 22°C und einer Stromdichte von 0,5 bis 2,5 A/dm$^2$ während 10 bis 60 min anodisch oxidiert wird. Die Schwefelsäurekonzentration in der wäßrigen Elektrolytlösung kann dabei auch bis auf 8 bis 10 Gew.-% $H_2SO_4$ (ca. 100 g $H_2SO_4$/l) verringert oder auch auf 30 Gew.-% (365 g $H_2SO_4$/l) und mehr erhöht werden.

- Die "Hartanodisierung" wird mit einem wäßrigen, $H_2SO_4$ enthaltenden Elektrolyten einer Konzentration von 166 g $H_2SO_4$/l (oder ca. 230 g $H_2SO_4$/l) bei einer Betriebstemperatur von 0° bis 5°C, bei einer Stromdichte von 2 bis 3 A/dm$^2$, einer steigenden Spannung von etwa 25 bis 30 V zu Beginn und etwa 40 bis 100 V gegen Ende der Behandlung und während 30 bis 200 min durchgeführt.

Neben den im vorhergehenden Absatz bereits genannten Verfahren zur anodischen Oxidation von Druckplatten-Trägermaterialien können beispielsweise noch die folgenden Verfahren zum Einsatz kommen: die anodische Oxidation von Aluminium in einem wäßrigen $H_2SO_4$ enthaltenden Elektrolyten, dessen $Al^{3+}$-Ionengehalt auf Werte von mehr als 12 g/l eingestellt wird (nach der DE-OS 28 11 396 = US-PS 4 211 619), in einem wäßrigen, $H_2SO_4$ und $H_3PO_4$ enthaltenden Elektrolyten (nach der DE-OS 27 07 810 = US-PS 4 049 504) oder in einem wäßrigen, $H_2SO_4$, $H_3PO_4$ und $Al^{3+}$-Ionen enthaltenden Elektrolyten (nach der DE-OS

HOECHST AKTIENGESELLSCHAFT
KALLE Niederlassung der Hoechst AG

- 10 -

28 36 803 = US-PS 4 229 226). Zur anodischen Oxidation wird bevorzugt Gleichstrom verwendet, es kann jedoch auch Wechselstrom oder eine Kombination dieser Stromarten (z. B. Gleichstrom mit überlagertem Wechselstrom) eingesetzt werden. Die Schichtgewichte an Aluminiumoxid bewegen sich im allgemeinen im Bereich von 1 bis 10 g/m$^2$, entsprechend einer Schichtdicke von etwa 0,3 bis 3,0 µm.

Der Stufe einer anodischen Oxidation des Druckplatten-Trägermaterials aus Aluminium können auch eine oder mehrere Nachbehandlungsstufen nachgestellt werden. Dabei wird unter Nachbehandeln insbesondere eine hydrophilierende chemische oder elektrochemische Behandlung der Aluminiumoxidschicht verstanden, beispielsweise eine Tauchbehandlung des Materials in einer wäßrigen Polyvinylphosphonsäure-Lösung nach der DE-PS 16 21 478 (= GB-PS 1 230 447), eine Tauchbehandlung in einer wäßrigen Alkalisilikat-Lösung nach der DE-AS 14 71 707 (= US-PS 3 181 461) oder eine elektrochemische Behandlung (Anodisierung) in einer wäßrigen Alkalisilikat-Lösung nach der DE-OS 25 32 769 (= US-PS 3 902 976). Diese Nachbehandlungsstufen dienen insbesondere dazu, die bereits für viele Anwendungsgebiete ausreichende Hydrophilie der Aluminiumoxidschicht noch zusätzlich zu steigern, wobei die übrigen bekannten Eigenschaften dieser Schicht mindestens erhalten bleiben.

Die erfindungsgemäße wäßrig-alkalische Entwicklerlösung ist grundsätzlich für alle positiv-arbeitenden Reproduktionsschichten geeignet, insbesondere jedoch für o-Chinondiazide, insbesondere o-Naphthochinondiazide wie Naphthochinon-(1,2)-diazid-(2)-sulfonsäureester oder -amide, die nieder- oder höhermolekular sein können, als strahlungsempfindliche Verbindung enthaltende Schichten. Diese Reproduktionsschichten enthalten neben mindestens einem dieser o-Chinondiazide alkalilösliche Harze, beispielsweise Phenolharze, Acryl- oder Methacrylsäuremischpolymerisate, Maleinsäuremischpolymerisate und andere zur Salzbildung befähigte Gruppen enthaltende Polymerisate; bevorzugt werden Phenolharze, insbesondere Novolake. Weitere mögliche Schichtbestandteile sind u. a. kleine Mengen alkalilöslicher Harze, Farbstoffe, Weichmacher, Haftverbesserungsmittel oder Tenside, solche Reproduktionsschichten werden beispielsweise in den DE-PSen 854 890, 865 109, 879 203, 894 959, 938 233, 1 109 521, 1 144 705, 1 118 606, 1 120 273, 1 124 817 und 2 331 377, und den EP-OSen 0 021 428 und 0 055 814 beschrieben.

Durch die Erfindung wird erreicht, daß die Bildstellen nach der Entwicklung eine verhältnismäßig steile Gradation und ein gutes Auflösevermögen zeigen. Es tritt dabei eine gute Differenzierung der Bildstellen von den Nichtbildstellen auf, d. h. die aufzulösenden Schichtbestandteile können rückstandslos entfernt werden, ohne daß eine Unterwanderung der Bildstellen stattfindet. Trotz der guten Entwicklungsleistung greift die erfindungsgemäße Entwicklerlösung die Trägermaterialien der Reproduktionsschicht, insbesondere Aluminiumoxidschichten nicht an, solange in der Praxis übliche Entwick-

HOECHST AKTIENGESELLSCHAFT
KALLE Niederlassung der Hoechst AG

- 12 -

lungszeiten angewandt werden. Verglichen mit Entwicklerlösungen aus dem Stand der Technik können auch höhere
Konzentrationen an Silikaten angewandt werden, ohne daß
es zu einem gleichwertig starken Oxidschichtangriff
kommt.

In den nachfolgenden Beispielen beziehen sich Prozentangaben auf das Gewicht, und Gew.-Teile stehen zu Vol.-
Teilen im Verhältnis von g zu $cm^3$.

Beispiele 1 bis 100 und Vergleichsbeispiele V1 bis V16

Eine elektrochemisch in Säure aufgerauhte und anodisch
oxidierte Aluminiumplatte (Oxidschichtgewicht von etwa
3 $g/m^2$) wird mit einer wäßrigen Polyvinylphosphonsäurelösung hydrophilierend in einer Tauchstufe nachbehandelt
und getrocknet. Auf das so vorbehandelte Trägermaterial
wird eine positiv-arbeitende lichtempfindliche Beschichtung aus (siehe EP-OS 0 055 814):

1,82 Gew.-Teilen eines Naphthochinondiazidsulfonsäureesters eines Diazostickstoffgehalts
von 4,7 %, hergestellt aus Naphtho-
chinon-(1,2)-diazid-(2)-5-sulfonsäurechlorid, Kresol-Formaldehyd-Novolak
und 2,3,4-Trihydroxy-benzophenon in
Gegenwart einer Base,
0,22 Gew.-Teilen Naphthochinon-(1,2)-diazid-(2)-4-
sulfonsäurechlorid,

HOECHST AKTIENGESELLSCHAFT
KALLE Niederlassung der Hoechst AG

- 13 -

0,07 Gew.-Teilen eines Kresol-Formaldehyd-Novolaks mit einem Schmelzbereich von 105 bis 120 °C (nach DIN 53 181), und

0,08 Gew.-Teilen Kristallviolett, in

91,19 Gew.-Teilen eines Gemisches aus 5 Vol.-Teilen Tetrahydrofuran, 4 Vol.-Teilen Ethylenglykolmonomethylether und 1 Vol.-Teil Essigsäure-butylester

aufgebracht, die nach dem Trocknen ein Schichtgewicht von 2,3 g/m$^2$ aufweist. Das so hergestellte Kopiermaterial wird unter einer gerasterten Positivvorlage bildmäßig während 1 min belichtet und anschließend mit einer der in der Tabelle angegebenen Entwicklerlösungen entwickelt. Die Entwicklungszeiten betragen 2 bzw. 10 min, wobei in allen Fällen nach 2 min praktisch noch kein Oxidschichtangriff stattfindet. Der Vergleich von erfindungsgemäß zusammengesetzten Entwicklerlösungen mit solchen, bei denen eine der Komponenten Silikat oder quaternäre Ammoniumbase weggelassen wurde, zeigt deutlich den erfindungsgemäßen Fortschritt, d. h. eine steilere Gradation in den Bildstellen und auch eine positive Beeinflussung des Oxidschichtangriffs (d. h. Verringerung). Wenn in erfindungsgemäßen Entwicklerlösungen der Benzoat-Zusatz weggelassen oder verringert wird, so tritt keine signifikante Änderung in den Meßwerten bezüglich der Gradation und des Auflösevermögens auf, eine gewisse Beeinflussung in Richtung auf einen geringeren Oxidschichtangriff ist jedoch bei Benzoat-Zusatz zu beobachten. In den Vergleichsbeispielen V6 bis V15 wurde als qua-

HOECHST AKTIENGESELLSCHAFT
KALLE Niederlassung der Hoechst AG

- 14 -

ternäre Ammoniumbase sowohl TEAH als auch TBMAH eingesetzt.

Als Maß für die Steilheit der Gradation wird die Differenz aus der ersten voll-gedeckten Keilstufe und der
letzten nicht-gedeckten Keilstufe auf einem Belichtungstestkeil mit 13 Stufen und einer Keilkonstante von 0,15
(Dichte der ersten Stufe beträgt 0,15, die der letzten
1,95; beispielsweise Kalle Belichtungstestkeil BK 01,
vertrieben von Kalle, Niederlassung der Hoechst AG) ermittelt. Je geringer die Differenz ist, desto steiler ist
die Gradation.

Das Auflösevermögen wird mit dem sogenannten "K-Feld" des
Fogra-Präzisionsmeßstreifens "PMS-K" bestimmt [siehe
"fogra praxis report" - Nr. 24, "Die FOGRA-Präzisions-
Meßstreifen", herausgegeben von der Deutschen Forschungsgesellschaft für Druck- und Reproduktionstechniken e. V.
(FOGRA), Januar 1979 - München]. Das "K-Feld" enthält 9
Teilfelder mit Spalten und Strichen in 9 verschiedenen
Breiten von 4 bis 40 μm. Jedes Teilfeld ist durch eine
Ziffer gekennzeichnet, welche die Strich- bzw. Spaltenbreite in μm angibt. Der sogenannte "K-Wert" (siehe Tabelle) mit Werten von 4 bis 40 bezeichnet jeweils das
feinste gerade noch wiedergegebene Strichfeld. Beträgt
der "K-Wert" beispielsweise 4, d. h. das Auflösevermögen
4 μm, so können 4 μm breite Striche und Spalten in einer
Kopie gerade noch getrennt wiedergegeben werden.

In den Beispielen wurde als Silikat immer ein $Na_2SiO_3$
$\cdot$ $9H_2O$ und als Benzoat ein Na-benzoat eingesetzt.

H O E C H S T   A K T I E N G E S E L L S C H A F T
KALLE  Niederlassung der Hoechst AG

Tabelle

| Bei-spiel Nr. | Gehalt der wäßrig-alkalischen Entwicklerlösung in Gew.-% an | | | Entwicklungsgeschwindigkeit | | | |
| | Silikat | Benzoat | quaternärer Ammoniumbase | nach 2 min Steilheit der Gradation | nach 10 min Steilheit der Gradation | Auflöse-vermögen | Oxidschicht-angriff |
|---|---|---|---|---|---|---|---|
| V 1 | 5,3 $\alpha$) | - | - | 7,0 | 8,0 | 4 | kein |
| V 2 | 6,0 | 1,0 | - | 7,0 | 7,5 | 6 | kein |
| V 3 | 8,0 | 1,0 | - | 6,5 | 8,5 | 8 | kein |
| V 4 | 10,0 | 1,0 | - | 10,0 | $\gamma$) | 12 | stark |
| V 5 | 12,0 | 1,0 | - | 10,0 | $\gamma$) | 12 | stark |
| V 6 | - | - | 0,01 | $-^{\delta}$) | - | - | - |
| V 7 | - | - | 0,10 | - | - | - | - |
| V 8 | - | - | 1,00 | - | - | - | - |
| V 9 | - | - | 5,00 | - | - | - | - |
| V10 | - | - | 10,00 | - | - | - | - |
| V11 | - | 1,0 | 0,01 | - | - | - | - |
| V12 | - | 1,0 | 0,10 | - | - | - | - |
| V13 | - | 1,0 | 1,00 | - | - | - | - |
| V14 | - | 1,0 | 5,00 | - | - | - | - |
| V15 | - | 1,0 | 10,00 | - | - | - | - |
| V16 | 7,2 $\beta$) | - | - | 7,0 | 6,0 | 6 | kein |

Tabelle (Fortsetzung I)

| Bei-spiel Nr. | Gehalt der wäßrig-alkalischen Entwicklerlösung in Gew.-% an | | | Entwicklungsgeschwindigkeit | | | |
|---|---|---|---|---|---|---|---|
| | | | | nach 2 min | nach 10 min | | |
| | Silikat | Benzoat | quaternärer Ammoniumbase⁻⁾ | Steilheit der Gradation | Steilheit der Gradation | Auflöse-vermögen | Oxidschicht-angriff |
| 1 | 6,0 | 1,0 | TMAH 0,01 | 4,0 | 6,0 | 4 | kein |
| 2 | 6,0 | 1,0 | " 0,02 | 5,0 | 6,0 | 4 | " |
| 3 | 6,0 | 1,0 | " 0,04 | +) | 6,0 | 4 | " |
| 4 | 6,0 | 1,0 | " 0,08 | +) | +) | 4 | " |
| 5 | 6,0 | 1,0 | " 0,10 | +) | +) | 4 | " |
| 6 | 6,0 | 1,0 | TEAH 0,01 | 3,0 | 5,0 | 4 | kein |
| 7 | 6,0 | 1,0 | " 0,02 | +) | 4,0 | 4 | " |
| 8 | 6,0 | 1,0 | " 0,04 | +) | +) | 4 | " |
| 9 | 6,0 | 1,0 | " 0,08 | +) | +) | +) | " |
| 10 | 6,0 | 1,0 | " 0,10 | +) | +) | +) | " |
| 11 | 6,0 | 1,0 | TPAH 0,01 | 3,5 | 4,0 | 4 | kein |
| 12 | 6,0 | 1,0 | " 0,02 | 3,0 | 3,0 | 4 | " |
| 13 | 6,0 | 1,0 | " 0,04 | 3,0 | 5,0 | 4 | " |
| 14 | 6,0 | 1,0 | " 0,08 | +) | +) | 4 | " |
| 15 | 6,0 | 1,0 | " 0,10 | +) | +) | 4 | " |

Tabelle (Fortsetzung II)

| Bei-spiel Nr. | Gehalt der wäßrig-alkalischen Entwicklerlösung in Gew.-% an | | | Entwicklungsgeschwindigkeit | | | |
| | Silikat | Benzoat | quaternärer Ammoniumbase[-)] | nach 2 min | nach 10 min | | |
| | | | | Steilheit der Gradation | Steilheit der Gradation | Auflöse-vermögen | Oxidschicht-angriff |
|---|---|---|---|---|---|---|---|
| 16 | 6,0 | 1,0 | TBAH 0,01 | 4,0 | 5,5 | 4 | kein |
| 17 | 6,0 | 1,0 | " 0,02 | 3,0 | 4,0 | 4 | " |
| 18 | 6,0 | 1,0 | " 0,04 | 3,0 | 3,5 | 4 | " |
| 19 | 6,0 | 1,0 | " 0,08 | 3,0 | 5,0 | 4 | " |
| 20 | 6,0 | 1,0 | " 0,10 | +) | +) | 4 | " |
| 21 | 6,0 | 1,0 | TBMAH 0,01 | 3,0 | 4,0 | 4 | kein |
| 22 | 6,0 | 1,0 | " 0,02 | 4,0 | 4,0 | 4 | " |
| 23 | 6,0 | 1,0 | " 0,04 | +) | +) | 4 | " |
| 24 | 6,0 | 1,0 | " 0,08 | +) | +) | 4 | " |
| 25 | 6,0 | 1,0 | " 0,10 | +) | +) | 4 | " |
| 26 | 8,0 | 1,0 | TMAH 0,01 | 5,0 | 5,0 | 6 | kein |
| 27 | 8,0 | 1,0 | " 0,02 | 5,0 | 5,0 | 6 | " |
| 28 | 8,0 | 1,0 | " 0,04 | 4,5 | 5,0 | 4 | " |
| 29 | 8,0 | 1,0 | " 0,08 | 5,0 | 4,5 | 4 | " |
| 30 | 8,0 | 1,0 | " 0,10 | 4,5 | 5,0 | 4 | " |

0101010

Tabelle (Fortsetzung III)

| Bei-spiel Nr. | Gehalt der wäßrig-alkalischen Entwicklerlösung in Gew.-% an | | | Entwicklungsgeschwindigkeit | | | |
|---|---|---|---|---|---|---|---|
| | | | | nach 2 min | nach 10 min | | |
| | Silikat | Benzoat | quaternärer Ammoniumbase | Steilheit der Gradation | Steilheit der Gradation | Auflöse-vermögen | Oxidschicht-angriff |
| 31 | 8,0 | 1,0 | TEAH 0,01 | +) | 5,0 | 4 | kein |
| 32 | 8,0 | 1,0 | " 0,02 | 2,0 | +) | 4 | " |
| 33 | 8,0 | 1,0 | " 0,04 | 2,0 | 2,5 | 4 | " |
| 34 | 8,0 | 1,0 | " 0,08 | 1,5 | 2,5 | 6 | " |
| 35 | 8,0 | 1,0 | " 0,10 | 3,0 | 5,0 | 6 | " |
| 36 | 8,0 | 1,0 | TPAH 0,01 | 3,5 | 4,0 | 6 | kein |
| 37 | 8,0 | 1,0 | " 0,02 | 2,0 | 6,0 | 6 | " |
| 38 | 8,0 | 1,0 | " 0,04 | 3,0 | 3,0 | 6 | " |
| 39 | 8,0 | 1,0 | " 0,08 | 3,0 | 5,0 | 4 | " |
| 40 | 8,0 | 1,0 | " 0,10 | 3,5 | 6,5 | 4 | " |
| 41 | 8,0 | 1,0 | TBAH 0,01 | 4,5 | 3,5 | 8 | kein |
| 42 | 8,0 | 1,0 | " 0,02 | 4,0 | 3,0 | 8 | " |
| 43 | 8,0 | 1,0 | " 0,04 | 3,0 | 2,5 | 6 | " |
| 44 | 8,0 | 1,0 | " 0,08 | 3,5 | 4,5 | 6 | " |
| 45 | 8,0 | 1,0 | " 0,10 | 3,0 | 4,5 | 6 | " |

Tabelle (Fortsetzung IV)

| Bei-spiel Nr. | Gehalt der wäßrig-alkalischen Entwicklerlösung in Gew.-% an | | | Entwicklungsgeschwindigkeit | | | |
|---|---|---|---|---|---|---|---|
| | | | | nach 2 min | nach 10 min | | |
| | Silikat | Benzoat | quaternärer Ammoniumbase⁻⁾ | Steilheit der Gradation | Steilheit der Gradation | Auflöse-vermögen | Oxidschicht-angriff |
| 46 | 8,0 | 1,0 | TBMAH 0,01 | 3,0 | 3,0 | 6 | kein |
| 47 | 8,0 | 1,0 | " 0,02 | 2,5 | 3,0 | 6 | " |
| 48 | 8,0 | 1,0 | " 0,04 | 3,0 | 5,0 | 4 | " |
| 49 | 8,0 | 1,0 | " 0,08 | 3,5 | 5,0 | 4 | " |
| 50 | 8,0 | 1,0 | " 0,10 | 4,0 | 5,5 | 4 | " |
| 51 | 10,0 | 1,0 | TMAH 0,01 | 5,0 | 6,0 | 6 | leicht |
| 52 | 10,0 | 1,0 | " 0,02 | 5,5 | 7,0 | 4 | " |
| 53 | 10,0 | 1,0 | " 0,04 | 5,0 | 5,0 | 4 | " |
| 34 | 10,0 | 1,0 | " 0,08 | 5,0 | 5,0 | 4 | " |
| 55 | 10,0 | 1,0 | " 0,10 | 4,0 | 4,5 | 4 | " |
| 56 | 10,0 | 1,0 | TEAH 0,01 | 3,0 | 4,0 | 6 | leicht |
| 57 | 10,0 | 1,0 | " 0,02 | 2,0 | 2,5 | 6 | " |
| 58 | 10,0 | 1,0 | " 0,04 | 2,5 | 2,5 | 6 | " |
| 59 | 10,0 | 1,0 | " 0,08 | 2,0 | 3,5 | 4 | " |
| 60 | 10,0 | 1,0 | " 0,10 | 4,5 | 5,0 | 4 | " |

Tabelle (Fortsetzung V)

| Bei-spiel Nr. | Gehalt der wäßrig-alkalischen Entwicklerlösung in Gew.-% an | | | Entwicklungsgeschwindigkeit | | | |
| | | | | nach 2 min | nach 10 min | | |
| | Silikat | Benzoat | quaternärer Ammoniumbase⁻⁾ | Steilheit der Gradation | Steilheit der Gradation | Auflöse-vermögen | Oxidschicht-angriff |
| 61 | 10,0 | 1,0 | TPAH 0,01 | 3,5 | 4,0 | 8 | leicht |
| 62 | 10,0 | 1,0 | " 0,02 | 3,5 | 5,0 | 8 | " |
| 63 | 10,0 | 1,0 | " 0,04 | 2,5 | 3,5 | 6 | " |
| 64 | 10,0 | 1,0 | " 0,08 | 3,0 | 3,5 | 6 | " |
| 65 | 10,0 | 1,0 | " 0,10 | 3,0 | 4,5 | 4 | " |
| 66 | 10,0 | 1,0 | TBAH 0,01 | 4,0 | 5,5 | 10 | leicht |
| 67 | 10,0 | 1,0 | " 0,02 | 3,5 | 4,0 | 8 | " |
| 68 | 10,0 | 1,0 | " 0,04 | 4,0 | 4,5 | 6 | " |
| 69 | 10,0 | 1,0 | " 0,08 | 4,0 | 5,0 | 6 | " |
| 70 | 10,0 | 1,0 | " 0,10 | 4,0 | 5,0 | 6 | " |
| 71 | 10,0 | 1,0 | TBMAH 0,01 | 2,5 | 3,0 | 6 | leicht |
| 72 | 10,0 | 1,0 | " 0,02 | 3,0 | 3,0 | 6 | " |
| 73 | 10,0 | 1,0 | " 0,04 | 3,0 | 4,0 | 6 | " |
| 74 | 10,0 | 1,0 | " 0,08 | 2,5 | 4,0 | 6 | " |
| 75 | 10,0 | 1,0 | " 0,10 | 3,0 | 5,0 | 4 | " |

HOECHST AKTIENGESELLSCHAFT KALLE Niederlassung der Hoechst AG

0101010

Tabelle (Fortsetzung VI)

| Bei-spiel Nr. | Gehalt der wäßrig-alkalischen Entwicklerlösung in Gew.-% an | | | Entwicklungsgeschwindigkeit | | | |
|---|---|---|---|---|---|---|---|
| | | | | nach 2 min | nach 10 min | | |
| | Silikat | Benzoat | quaternärer Ammoniumbase[-] | Steilheit der Gradation | Steilheit der Gradation | Auflöse-vermögen | Oxidschicht-angriff |
| 76 | 12,0 | 1,0 | TMAH 0,01 | 8,0 | 11,0 | 6 | stark |
| 77 | 12,0 | 1,0 | " 0,02 | 9,0 | 10,0 | 6 | " |
| 78 | 12,0 | 1,0 | " 0,04 | 7,0 | 8,5 | 6 | " |
| 79 | 12,0 | 1,0 | " 0,08 | 6,0 | 7,5 | 6 | " |
| 80 | 12,0 | 1,0 | " 0,10 | 6,0 | 6,0 | 4 | " |
| 81 | 12,0 | 1,0 | TEAH 0,01 | 4,0 | 6,0 | 6 | stark |
| 82 | 12,0 | 1,0 | " 0,02 | 3,5 | 6,0 | 8 | " |
| 83 | 12,0 | 1,0 | " 0,04 | 1,5 | 2,0 | 6 | " |
| 84 | 12,0 | 1,0 | " 0,08 | 1,0 | 2,5 | 4 | " |
| 85 | 12,0 | 1,0 | " 0,10 | 3,0 | 6,0 | 6 | " |
| 86 | 12,0 | 1,0 | TPAH 0,01 | 3,5 | 5,0 | 10 | stark |
| 87 | 12,0 | 1,0 | " 0,02 | 2,5 | 7,0 | 6 | " |
| 88 | 12,0 | 1,0 | " 0,04 | 2,0 | 3,0 | 8 | leicht |
| 89 | 12,0 | 1,0 | " 0,08 | 2,0 | 4,0 | 6 | stark |
| 90 | 12,0 | 1,0 | " 0,10 | 2,5 | 5,0 | 6 | " |

| Bei-spiel Nr. | Gehalt der wäßrig-alkalischen Entwicklerlösung in Gew.-% an | | | Entwicklungsgeschwindigkeit | | | |
|---|---|---|---|---|---|---|---|
| | | | | nach 2 min | nach 10 min | | |
| | Silikat | Benzoat | quaternärer Ammoniumbase-) | Steilheit der Gradation | Steilheit der Gradation | Auflöse-vermögen | Oxidschicht-angriff |
| 91 | 12,0 | 1,0 | TBAH 0,01 | 5,0 | 7,0 | 10 | leicht |
| 92 | 12,0 | 1,0 | " 0,02 | 4,0 | 6,0 | 10 | " |
| 93 | 12,0 | 1,0 | " 0,04 | 3,0 | 4,0 | 8 | stark |
| 94 | 12,0 | 1,0 | " 0,08 | 3,0 | 5,0 | 8 | " |
| 95 | 12,0 | 1,0 | " 0,10 | 4,0 | 6,0 | 6 | " |
| 96 | 12,0 | 1,0 | TBMAH 0,01 | 4,0 | 6,0 | 8 | stark |
| 97 | 12,0 | 1,0 | " 0,02 | 3,0 | 4,0 | 8 | " |
| 98 | 12,0 | 1,0 | " 0,04 | 3,0 | 4,0 | 8 | " |
| 99 | 12,0 | 1,0 | " 0,08 | 3,0 | 6,0 | 8 | " |
| 100 | 12,0 | 1,0 | " 0,10 | 3,0 | 5,5 | 6 | " |

α) weitere Bestandteile sind 3,4 Gew.-% $Na_3PO_4 \cdot 12H_2O$ und 0,3 Gew.-% $NaH_2PO_4$

β) weitere Bestandteile sind 0,02 Gew.-% $Sr^{3+}$-Ionen und 0,03 Gew.-% Lävulinsäure

γ) eine voll gedeckte Keilstufe ist bei der vorgegebenen Belichtungszeit nicht mehr zu ermitteln

δ) eine Aufentwicklung (d. h. Differenzierung in Bild- und Nichtbildstellen) findet nicht statt

+) In den Nichtbildstellen tritt "Ton" auf

-) Prozentangaben beziehen sich immer auf eine 20%ige wäßrige Lösung, d. h. 0,01 % bedeutet tatsächlich 0,002 % Wirkstoff

HOECHST AKTIENGESELLSCHAFT
KALLE Niederlassung der Hoechst AG

0101010

HOECHST AKTIENGESELLSCHAFT
KALLE Niederlassung der Hoechst AG

Hoe 82/K 043      - 23 -      2. August 1983
                                         WLK-Dr.I.-wf

## Patentansprüche

1 Wäßrig-alkalische Entwicklerlösung für strahlungsempfindliche, positiv-arbeitende Reproduktionsschichten auf der Basis von Silikaten und mindestens einer weiteren Komponente, dadurch gekennzeichnet, daß sie eine quaternäre Ammoniumbase enthält.

2 Entwicklerlösung nach Anspruch 1, dadurch gekennzeichnet, daß sie als quaternäre Ammoniumbase ein Tetraalkyl-ammoniumhydroxid enthält, dessen Alkylsubstituenten gleich oder verschieden sind und ein bis sechs C-Atome enthalten.

3 Entwicklerlösung nach Anspruch 1 oder 2, dadurch gekennzeichnet, daß sie zusätzlich ein Salz einer organischen, gegebenenfalls substituierten aromatischen Monocarbonsäure enthält.

4 Entwicklerlösung nach Anspruch 3, dadurch gekennzeichnet, daß sie ein Salz der gegebenenfalls substituierten Benzoesäure enthält.

5 Entwicklerlösung nach einem der Ansprüche 1 bis 4, dadurch gekennzeichnet, daß sie 5 bis 15 Gew.-% Silikat und 0,001 bis 1,0 Gew.-% der quaternären Ammoniumbase enthält.

6 Entwicklerlösung nach einem der Ansprüche 3 bis 5,

HOECHST AKTIENGESELLSCHAFT
KALLE Niederlassung der Hoechst AG

- 24 -

dadurch gekennzeichnet, daß sie 0,01 bis 10,0 Gew.-%
des Salzes enthält.

7 Verfahren zum Entwickeln von belichteten, strahlungsempfindlichen, positiv-arbeitenden Reproduktionsschichten auf einem Trägermaterial auf der Basis von
Aluminium, bei dem die belichteten Schichtbereiche mit
einer wäßrig-alkalischen Entwicklerlösung ausgewaschen
werden, die Silikate und mindestens eine weitere Komponente enthält, dadurch gekennzeichnet, daß man eine
Entwicklerlösung einsetzt, die eine quaternäre Ammoniumbase enthält.

8 Verfahren nach Anspruch 7, dadurch gekennzeichnet, daß
die Entwicklerlösung zusätzlich ein Salz einer organischen, gegebenenfalls substituierten, aromatischen
Monocarbonsäure enthält.

9 Verfahren nach Anspruch 7 oder 8, dadurch gekennzeichnet, daß die Reproduktionsschicht ein o-Naphthochinondiazid als strahlungsempfindliche Verbindung und ein
alkalilösliches Harz enthält.

10 Verfahren nach einem der Ansprüche 7 bis 9, dadurch
gekennzeichnet, daß das Trägermaterial mindestens
eine anodisch erzeugte Aluminiumoxidschicht aufweist.

-----

## EUROPÄISCHER RECHERCHENBERICHT

Europäisches
Patentamt

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| Y,D | GB-A-1 591 988 (VICKERS LTD.) * Seite 2, Zeilen 7-25; Seite 2, Zeilen 34-37; Beispiele 1,4 * | 1-10 | G 03 F 7/26 G 03 F 2/08 |
| Y | JAPANESE PATENTS REPORT, Band 78, Nr. 8, Sektion G, 16.-22. Februar 1978/ 24. März 1978, Derwent Publications, London, GB. & JP - B - 78 004 423 (SAN EI CHEM. IND. K.K.) (Cat. D.) 17.02.1978 * Zusammenfassung * | 1-10 | |
| Y,D | IBM TECHNICAL DISCLOSURE BULLETIN, Band 13, Nr. 7, Dezember 1970, Seite 2009, New York, USA M.J. GRIECO et al.: "Photoresist developer compounds" * Insgesamt * | 1-10 | |
| Y | IBM TECHNICAL DISCLOSURE BULLETIN, Band 16, Nr. 2, Juli 1973, Seite 426, New York, USA J.J. DiFAZIO et al.: "Positive photoresist development process" * Insgesamt * | 1-10 | RECHERCHIERTE SACHGEBIETE (Int. Cl. ³) B 41 N 3/08 G 03 C 5/00 G 03 F 7/08 G 03 F 7/10 G 03 F 7/26 |
| Y,D | EP-A-0 023 758 (EASTMAN KODAK CY.) * Seite 2, Zeilen 3-22; Seite 5, Zeilen 3-20 * | 1,7 | |

--- -/-

Der vorliegende Recherchenbericht wurde für alle Patentansprüche erstellt.

| Recherchenort DEN HAAG | Abschlußdatum der Recherche 13-10-1983 | Prüfer MARKOWSKI V.F. |
|---|---|---|

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| Y | FR-A-2 185 631 (PHILIP A. HUNT CHEMICAL CORP.) <br> * Seite 3, Zeile 23 - Seite 4, Zeile 33; Beispiel 3 * <br><br> --- | 1-10 | |
| A | EP-A-0 056 092 (HOECHST AG.) <br> * Beispiele * <br><br> ----- | 1-10 | |
| | | | **RECHERCHIERTE SACHGEBIETE (Int. Cl. ³)** |

Der vorliegende Recherchenbericht wurde für alle Patentansprüche erstellt.

| Recherchenort <br> DEN HAAG | Abschlußdatum der Recherche <br> 13-10-1983 | Prüfer <br> MARKOWSKI V. F. |
|---|---|---|